# EUROPÄISCHE PATENTANMELDUNG

(11) **EP 0 692 724 A1**
(43) Veröffentlichungstag der Anmeldung: **17.01.1996**
(21) Anmeldenummer: 95108102.5
(22) Anmeldetag: 27.05.1995
(51) Int. Cl.: G02B 6/42, H01L 33/00, H01L 21/58

(54) **Verfahren zum Herstellen und Justieren eines Halbleiterbauelements**

(30) Priorität: 01.07.1994 DE 4423112
(71) Anmelder: ROBERT BOSCH GMBH, D-70442 Stuttgart (DE)
(72) Erfinder: Kragl, Hans, Dr. Dipl.-Ing., D-64372 Ober-Ramstadt (DE); Klockenbrink, Ralf, Dipl.-Ing., D-38118 Braunschweig (DE); Wehmann, Hergo-Heinrich, Dr. Dipl.-Ing., D-38527 Meine (DE)

(57) **Zusammenfassung**

Es wird ein Verfahren vorgeschlagen, das dazu dient, ein Halbleiterbauelement (12) herzustellen und auf einem Trägersubstrat (9) zu justieren, wobei eine Justiermaske (3) für eine Justiernut (8) gemeinsam mit einer Bauelementmaske (2) für das Halbleiterbauelement (12) auf ein Halbleitersubstrat (1) aufgebracht wird, die Justiernut (8) durch ein Ätzverfahren unter Zuhilfenahme der Justiermaske (3) hergestellt wird, das Halbleiterbauelement (12) unter Zuhilfenahme der Bauelementmaske (2) hergestellt und in seiner Position festgelegt wird und das Halbleitersubstrat (1) auf das Trägersubstrat (9) aufgesetzt wird, wobei die Lage des Halbleitersubstrats (1) relativ zum Trägersubstrat (9) mittels der Justiernut (8) oder einer durch die Justiermaske (3) festgelegten Kante und einem Justierelement (10) justiert wird.

## Beschreibung

### Stand der Technik

Die Erfindung geht aus von einem Verfahren nach der Gattung der nebengeordneten Ansprüche 1 und 2.

Aus dem Artikel "Hybrid Integration of Semiconductor Lasers with Si-Based Single-Mode Ridge Waveguides" von Friedrich, Öberg, Broberg, Nilsson und Valette in der Fachzeitschrift "Journal of Lightwave Technology", Vol. 10, Nr. 4, March 1992 ist es bekannt, ein Laserbauelement auf ein Substrat aufzusetzen, das einen Wellenleiter aufweist. Das Laserbauelement befindet sich auf einem Halbleitersubstrat. Die Justierung der Lage des Laserbauelements relativ zum Wellenleiter geschieht dabei durch folgende Schritte: Zuerst erfolgt ein Ätzen von Spaltnuten entlang der Halbleitersubstratoberfläche. Die Spaltnuten sind dabei in Form einer Perforation ausgebildet. Das Halbleitersubstrat wird dann entlang dieser Spaltnuten gebrochen und eine Justierung durch Einlegen des erhaltenen Laserchips in eine Justierstruktur auf dem Substrat erreicht. Die Justierung erfolgt dabei über die Bruchkante des Laserchips. Die Bruchkante weist eine relativ unbestimmte Oberfläche auf, was die Genauigkeit der Justierung verringert.

### Vorteile der Erfindung

Das erfindungsgemäße Verfahren mit den kennzeichnenden Merkmalen der nebengeordneten Ansprüche 1 und 2 hat demgegenüber den Vorteil, daß eine äußerst präzise Justierung der Lage eines Halbleiterbauelements relativ zu einem Trägersubstrat erreicht wird, ohne auf ein aktives Justierverfahren zurückzugreifen. Dies wird dadurch erreicht, daß die exakt definierte Oberfläche einer geätzten Justiernut zusammen mit einem auf dem Trägersubstrat angeordneten Justierelement, zur Justierung genutzt wird, wobei die Position der Justiernut auf dem Halbleitersubstrat im selben Verfahrensschritt definiert wird, in dem auch die Position des Halbleiterbauelements auf dem Halbleitersubstrat definiert wird.

Durch die in den Unteransprüchen aufgeführten Maßnahmen sind vorteilhafte Weiterbildungen und Verbesserungen der in den Ansprüchen 1 und 2 angegebenen Verfahren möglich.

Die Verwendung eines Polymerkunststoffs als Trägersubstrat öffnet dem erfindungsgemäßen Verfahren das Gebiet der Polymerkunststoffe, wodurch besonders preiswert und einfach herzustellende Hybridschaltungen produzierbar sind.

Die Befestigung des Halbleitersubstrats am Trägersubstrat mittels eines Klebstoffs bietet den Vorteil, daß die exakte Position des Halbleitersubstrats relativ zum Trägersubstrat nach dem Justiervorgang auch bei Erschütterungen oder Lageveränderungen erhalten bleibt.

Ein weiterer Vorteil ist gegeben, wenn das Halbleiterbauelement als optisches Bauelement ausgebildet ist und im Trägersubstrat eine zugehörige Wellenleiternut zur Aufnahme eines optischen Wellenleiters eingebettet wird, da insbesondere in der Optik eine höchst präzise Justierung zwischen den optischen Komponenten im Halbleiterbauelement und im Trägersubstrat nötig ist, um Koppelverluste gering zu halten.

Ebenso vorteilhaft ist es, als Trägersubstrat einen Formstempel zu verwenden, auf dem das Halbleitersubstrat mit einem aushärtbaren Kunststoff umgossen wird, so daß ein als Deckel für weitere Substrate verwendbares Bauteil entsteht, das nach dem Aushärten des Kunststoffs vom Formstempel entfernt wird, da durch den mehrfach verwendbaren Formstempel eine preiswerte Massenfertigung von präzise justierten Halbleiterbauelementen in Bauteilen für integriert optische Schaltungen realisierbar ist, wobei die Bauteile außerdem aufgrund ihrer größeren Abmessungen wesentlich einfacher handhabbar und justierbar sind.

Das Erzeugen einer Nut im entstehenden Bauteil, welche mit einem optisch transparenten Kleber gefüllt wird, um einen Wellenleiter zu erhalten, dient in vorteilhafter Weise der aufwandsarmen Herstellung eines Bauteils, welches einen exakt zum Halbleiterbauelement justierten Wellenleiter enthält und als Deckel mit dem darin eingebetteten Wellenleiter auf ein weiteres Substrat aufsetzbar ist.

Das Brechen des Halbleitersubstrats entlang der Justiernut bringt den Vorteil mit sich, daß mehrere Halbleiterbauelemente, die im selben Verfahrensschritt auf einem gemeinsamen Halbleitersubstrat produziert wurden, voneinander getrennt, d.h. vereinzelt, und auf verschiedene Trägersubstrate aufgesetzt werden können. Somit werden mittels dieses Schritts viele Herstellungsverfahren durch ein einziges Herstellungsverfahren ersetzt, was einen Kosten- und Zeitvorteil bedeutet.

Es erweist sich außerdem als vorteilhaft, wenn die Justiernutspitze auf einer dachfirstförmigen Erhebung plaziert wird, das es herstellungstechnisch besonders einfach ist, eine in ihrer Lage präzise definierte Justiernutspitze herzustellen und da die Spitze außerdem gleichzeitig eine Justierung in zwei entgegengesetzte Richtungen bewirkt.

Des weiteren tritt der Vorteil auf, daß die zur Definition der Lage des Halbleiterbauelements und der Justiernut verwendete Maske gleichzeitig auch als elektrischer Kontakt für das Halbleiterbauelement verwendet werden kann, indem ein leitfähiges Maskenmaterial ausgewählt wird. Ein dielektrisches Material ist andererseits vorteilhaft dazu geeignet, als Diffusionsmaske für die Herstellung des Halbleiterbauelements zu fungieren, und eine Maske aus einem Halbleitermaterial kann als funktioneller Teil des Halbleiterbauelements dienen.

Bei der Bedeckung des Halbleitersubstrats mit einer Photolackschicht und einer Zusatzschicht handelt es sich um eine vorteilhafte Ausgestaltung, da durch diese Doppelschicht die Gefahr einer Beschädigung des Halbleiterbauelements beim Ätzvorgang für die Justiernut reduziert wird.

Die Verwendung der Bauelementmaske als Maske für einen Diffusions- oder Implantationsvorgang zur Herstellung des Halbleiterbauelements bietet den weiteren Vorteil, daß keine zusätzliche Maskierung für den jeweiligen Vorgang bereitgestellt werden muß.

Das Aufbringen von weiteren Halbleiterschichten auf das Halbleitersubstrat dient in vorteilhafter Weise der Anwendbarkeit des Verfahrens für mehrschichtige Halbleiterbauelemente, wie beispielsweise Pilzlaser und ist außerdem geeignet, die Präzision der Justiernut zu erhöhen.

### Zeichnung

Ausführungsbeispiele der Erfindung sind in der Zeichnung dargestellt und in der nachfolgenden Beschreibung näher erläutert.

Es zeigen:
Figur 1 ein Halbleitersubstrat mit Justiermaske und Bauelementmaske,
Figur 2 ein Halbleitersubstrat mit eingeätzter Justiernut,
Figur 3 ein auf einem Trägersubstrat aufgesetztes Halbleitersubstrat mit Justierung mittels der Justiermaske,
Figur 4 ein auf einem Trägersubstrat aufgesetztes Halbleitersubstrat mit gebrochener Justiernut,
Figur 5 ein auf einem Trägersubstrat aufgesetztes Halbleitersubstrat mit Justierung mittels der Justiernutspitze.

### Beschreibung der Ausführungsbeispiele

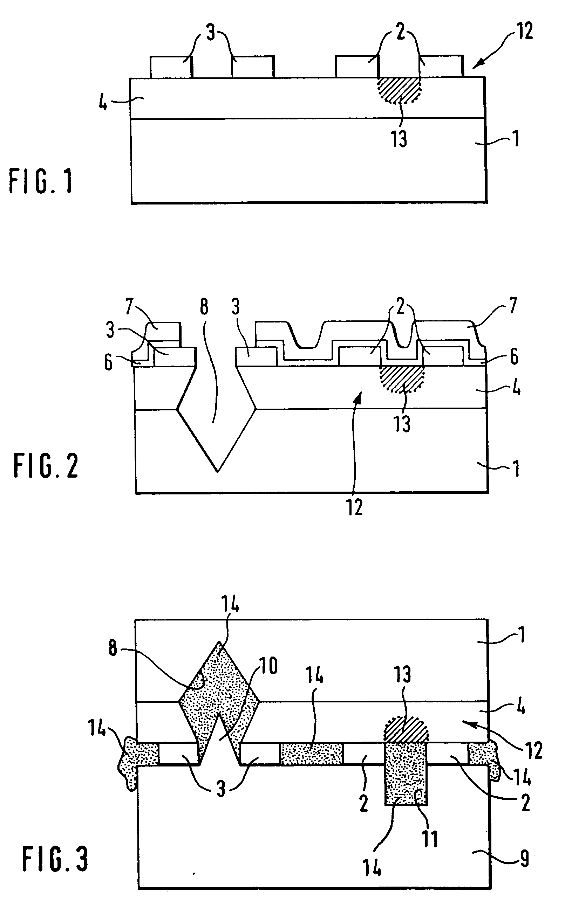

In Figur 1 ist ein Halbleitersubstrat 1 dargestellt, auf dessen Oberseite eine Halbleiterschicht 4 aufgebracht ist. Auf der Halbleiterschicht 4 wiederum ist eine Justiermaske 3 und eine Bauelementmaske 2 angeordnet. Die Masken 2, 3 bedecken die Halbleiterschicht 4 nur teilweise. Im Ausführungsbeispiel besteht sowohl die Bauelementmaske 2, als auch die Justiermaske 3 je aus zwei streifenförmigen Schichten, die nebeneinander mit einem Zwischenraum angeordnet sind. Die Halbleiterschicht 4 weist im Bereich zwischen den streifenförmigen Schichten der Bauelementmaske 2 eine aktive Zone 13 auf. Die Bauelementmaske 2 bildet zusammen mit dem darunterliegenden Bereich der Halbleiterschicht 4 und der aktiven Zone 13 ein Halbleiterbauelement 12.

Die Herstellung der gezeigten Anordnung erfolgt mit folgenden Methoden: Die Herstellung der Halbleiterschicht 4 erfolgt beispielsweise epitaktisch, und die Herstellung der Masken 2, 3 erfolgt mit einem in der Halbleitertechnik üblichen photolithographischen Verfahren mit den Prozeßschritten: -Aufbringen eines Photolacks, -Belichten des Photolacks mittels einer strukturierten Lichtmaske, -Auswaschen des Photolacks, - Ätzen des unter dem Photolack freiliegenden Materials, -Entfernen des Photolacks. Ebenso geeignet ist die bekannte Lift-off Technik. Die Justiermaske 3 wird im selben photolithographischen Verfahrensschritt und aus demselben Material hergestellt, wie die Bauelementmaske 2. Die beiden Masken 2, 3 sind daher als eine einzige Maske betrachtbar. Als Material dient vorzugsweise ein elektrisch leitfähiges Material, wie z.B. Metall, da es gleichzeitig als Kontakt für das Halbleiterbauelement 12 dienen kann. Es sind jedoch ebenso andere Materialien geeignet, wie Halbleiter, Dielektrika oder Kunststoffe. Die aktive Zone 13 wird durch die Geometrie der Bauelementmaske 2 festgelegt. Innerhalb dieser aktiven Zone 13 finden die elektrooptischen Effekte statt, die für die Funktion des Halbleiterbauelements 12 dienlich sind. Im Falle einer MSM-Struktur entsteht das Halbleiterbauelement 12 lediglich durch das Aufbringen der Bauelementmaske 2. Die Bauelementmaske 2 kann aber ebenso als Maske für einen Diffusionsvorgang, z.B. einen Dotiervorgang dienen, wobei vorzugsweise ein dielektrisches Material als Material für die Bauelementmaske 2 verwendet wird. In einem in der Zeichnung nicht dargestellten Verfahrensschritt wird dazu die gesamte Oberfläche der Halbleiterschicht 4 bis auf die zwischen den streifenförmigen Schichten der Bauelementmaske 2 befindliche Zone mit einer Schutzschicht abgedeckt und die Zone zwischen den zwei Streifen der Bauelementmaske 2 mit einem Dotiermaterial dotiert. Dadurch entsteht zwischen den beiden Streifen der Bauelementmaske 2 eine Dotierung in der aktiven Zone 13. Alternativ ist auch ein Implantationsvorgang zur Herstellung des Halbleiterbauelements 12 einsetzbar. Solche Diffusions-, Implantationsvorgänge oder auch epitaktische Verfahren können auch vor dem Herstellen der Masken 2, 3 erfolgen.

In Figur 2 ist die Anordnung aus Figur 1 dargestellt, wie sie nach weiteren Verfahrensschritten vorliegt. Dazu wurde die Anordnung aus Figur 1 mit einer Zusatzschicht 6 und einer mit der Zusatzschicht 6 deckungsgleichen, darüber liegenden Photolackschicht 7 versehen. Beide Schichten 6, 7 bedecken dabei die gesamte Oberfläche der Halbleiterbauelements 12 sowie die Oberfläche der Halbleiterschicht 4 bis auf die zwischen den Streifen der Justiermaske 3 liegende Zone. Die Ränder der Zusatzschicht 6 bzw. Photolackschicht 7 enden dabei auf der Justiermaske 3. Zwischen den streifenförmigen Schichten der Justiermaske 3 befindet sich eine Justiernut 8, deren Querschnitt sich in diesem Ausführungsbeispiel im Verlauf der Halbleiterschicht 4 erweitert und im Verlauf des Halbleitersubstrats 1 wieder verjüngt.

Die Justiernut 8 entsteht durch ein selektives Ätzverfahren. Die Auswahl der Materialien für die Halbleiterschicht 4 und das Halbleitersubstrat 1 sowie die Ausrichtung der Kristallebenen der Halbleiterschicht 4 und des Halbleitersubstrats 1 bezüglich ihrer Oberflächen kann so eingestellt werden, daß, wie in Figur 2 dargestellt, sich der Nutquerschnitt innerhalb der Halbleiterschicht 4 vergrößert und sich innerhalb des Halbleitersubstrats 1 wieder verjüngt. Ebenso sind aber auch andere Querschnittsänderungen einstellbar (siehe Figur 5). Vorteilhaft ist dabei z.B. die Auswahl eines ternären Halbleitermaterials für die Halbleiterschicht 4 und eines binären Halbleitermaterials für das Halbleitersubstrat 1. Die Zusatzschicht 6 dient dabei der Sicherheit, daß das Halbleiterbauelement 12 beim Ätzprozeß für die Justiernut 8 nicht angegriffen wird. Die Strukturierung der Zusatzschicht 6 erfolgt dabei ebenfalls photolithographisch mittels der Photolackschicht 7. Die Photolackschicht 7 kann nach diesem Photolithographieprozeß auf der Zusatzschicht 6 verbleiben und nach dem Ätzverfahren für die Justiernut 8 zusammen mit der Zusatzschicht 6 entfernt werden. Die Verwendung der Zusatzschicht 6 ist vor allem dann vorteilhaft, wenn kein Photolack bereitsteht, der eine genügende Resistenz gegen die Säure aufweist, mittels derer die Justiernut 8 geätzt wird. Die Präzision des Photolithographieprozesses für die Photolackschicht 7 und die Zusatzschicht 6 erfordert eine wesentlich geringere Genauigkeit, als der vorhergehende Photolithographieprozeß für die Masken 2, 3, da der Rand der Schichten 6, 7 nur im Bereich auf der Justiermaske 3 liegen muß und somit eine größere Toleranz vorliegt. Nach dem Ätzen der Justiernut 8 werden die Schichten 7, 6 entfernt.

In Figur 3 ist das auf ein Trägersubstrat 9 aufgesetzte Halbleitersubstrat 1 mit der Justiernut 8 und dem Halbleiterbauelement 12 dargestellt. Das Trägersubstrat 9 weist hierzu ein Justierelement 10 auf, das in Form einer dachfirstförmigen Erhebung ausgebildet ist. Die dachfirstförmige Erhebung 10 ragt in die Justiernut 8 hinein und schließt an ihrer Basis exakt mit den Rändern der Justiermaske 3 ab. Die Streifen der Bauelementmaske 2 liegen ebenfalls auf der Oberfläche des Trägersubstrats 9 auf, wobei die aktive Zone 13 des Halbleiterbauelements 12 exakt über einer Wellenleiternut 11 liegt, die in die Oberfläche des Trägersubstrats 9 einstrukturiert ist.

Das Trägersubstrat 9 besteht hier aus einem Polymerkunststoff. Zur Herstellung einer Verbindung zwischen einerseits dem Halbleitersubstrat 1 mit dem Halbleiterbauelement 12 und der Justiernut 8 und andererseits dem Trägersubstrat 9 mit dem Justierelement 10 und der Wellenleiternut 11 wird ein optisch transparenter Klebstoff 14 zwischen die aufeinanderzusetzenden Oberflächen gebracht, der hier ebenfalls aus einem Polymerkunststoff besteht und einen etwas höheren Brechungsindex als das Trägersubstrat 9 aufweist. Der Klebstoff 14 füllt dabei auch die Wellenleiternut 11 aus und bildet zusätzlich zu seinen Hafteigenschaften gleichzeitig einen optischen Wellenleiter, der optisch an das Halbleiterbauelement 12 angekoppelt ist.

Die Justierung des Halbleitersubstrats 1 relativ zum Trägersubstrat 9 erfolgt hier über die Kanten der Justiermaske 3 und das Justierelement 10. Ebenso ist vorgesehen, die Justiermaske 3 vor dem Aufsetzen auf das Trägersubstrat 9 vom Halbleitersubstrat 1 abzulösen, so daß die Justierung dann über die beim Ätzprozeß der Justiernut 8 entstandenen Kanten der Justiernut 3 erfolgt. Dadurch, daß die Justiermaske 3 und die die Lage des Halbleiterbauelements bestimmende Bauelementmaske 2 im selben photolithographischen Prozeß hergestellt wurden, ist eine relative Verschiebung der beiden Masken 2, 3 zueinander ausgeschlossen. Dies gilt auch für die relative Lage des Justierelements 10 zur Justiernut 11 im Trägersubstrat 9. Als einzige Positionierungsfehler können somit Abbildungs- oder Positionierungsfehler des Prozesses zur Herstellung der Masken 2, 3, oder zur Herstellung des Justierelements 10 oder der Wellenleiternut 11 auftreten. Außerdem dient hier die durch den Photolithographieprozeß und das nachfolgende Ätzen sehr präzise und scharf definierte Kante der Justiermaske 3 als Justiermittel. Somit wird eine äußerst präzise Justierung des Halbleiterbauelements 12 bezüglich des in der Wellenleiternut 11 entstehenden optischen Wellenleiters erreicht. Es ist ebenso vorgesehen, das Trägersubstrat 9 als mehrfach verwendbaren Formstempel auszubilden, der dann allerdings keine Wellenleiternut 11 aufweist. Diese Ausgestaltung wird im Zusammenhang mit Figur 5 noch erläutert werden.

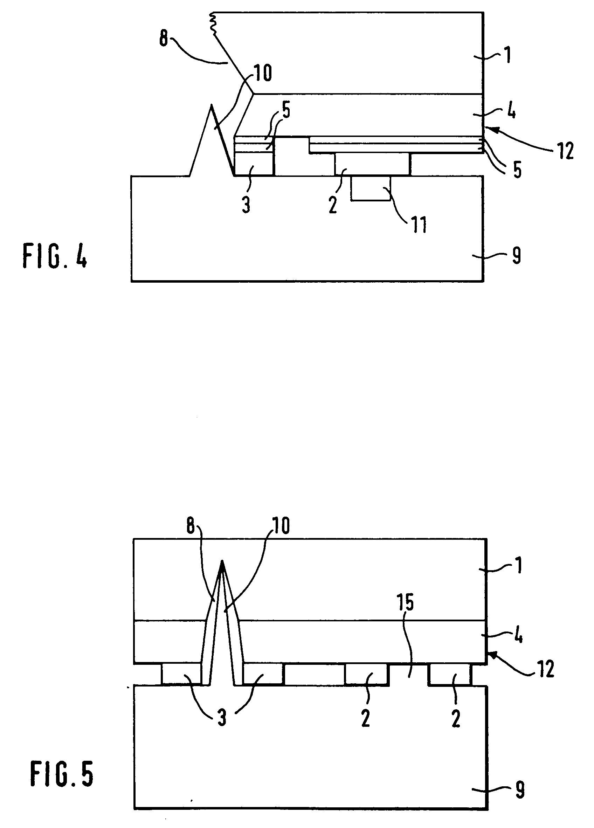

In Figur 4 ist eine weitere Variante des beschriebenen Verfahrens dargestellt. Die Anordnung aus Figur 2 wurde hier nach dem Entfernen der Photolackschicht 7 und der Zusatzschicht 6 entlang der Justiernut 8 gebrochen. Als weiterer Unterschied zur Anordnung aus Figur 2 wurde hier beim Herstellungsprozeß des Halbleiterbauelements 12 vor dem Photolithographieschritt für die Herstellung der Justiermaske 3 und der Bauelementmaske 2 ein weiterer Verfahrensschritt eingefügt, bei dem weitere Halbleiterschichten 5 auf der Oberfläche der Halbleiterschicht 4 im Bereich, wo das Halbleiterbauelements 12 entstehen soll und, wo die Justiermaske 3 liegen soll, abgeschieden wurden, bzw. ganzflächig abgeschieden und nachträglich strukturiert wurden. Die Bauelementmaske 2 besteht in diesem Falle nur aus einem Streifen.

Das Brechen ist besonders einfach möglich, da die entstehende Bruchstelle durch die dünne Materialstärke der Justiernut 8 an ihrer Spitze als Sollbruchstelle ausgebildet ist. Zur Verbesserung des Sollbrucheffekts kann die Kristallorientierung des Halbleitersubstrats 1 entsprechend gewählt werden. So ist insbesondere ein Trennen einer auf einem zusammenhängenden Halbleitersubstrat 1 bestehenden Anordnung vieler Halbleiterbauelemente 12 in einzelne Halbleiterbauelemente 12 möglich. Die Justierung des Halbleitersubstrats 1 gegenüber dem Trägersubstrat 9 geschieht hierbei nur über eine Kante der Justiermaske 3. Die durch das Aufbringen der weiteren Halbleiterschichten 5 entstandene mehrschichtige Struktur für das Halbleiterbauelement 12 kann z.B. zur Herstellung eines Pilzlasers verwendet werden. Außerdem kann eine Erhöhung der Genauigkeit des Justierverfahrens erreicht werden, da das Ausmaß der Unterätzung unterhalb der Justiermaske 3 durch geeignete Materialwahl für die weiteren Halbleiterschichten 5 verringert werden kann. Die hier gezeigte Justiermethode kann nur eine Justierung in einer Richtung bewirken. Es ist daher weiter vorgesehen, weitere solcher Justieranordnungen anzubringen, die für eine Justierung in eine andere Richtung geeignet sind. Das Brechen entlang der Sollbruchstelle findet vor allem Anwendung bei der Vereinzelung von zusammen auf dem selben Halbleitersubstrat 1 hergestellten Bauelementen 12. Das Brechen erfolgt zum Beispiel durch Aufkleben eines viele Halbleiterbauelemente 12 umfassenden Wafers auf eine Folie und durch Ausübung von leichtem Druck auf die Folie, so daß die Sollbruchstellen brechen.

In Figur 5 ist ein weiteres Beispiel für die Verwendung der Justiernut 8 als Justierhilfe dargestellt. Das Trägersubstrat 9 weist wiederum das dachfirstförmige Justierelement 10 auf, dessen Spitze in die Spitze der Justiernut 8 ragt. Diese Spitze ist insofern zu Justierung geeignet, als der Herstellungsprozeß für die Justiernut 8 so ausgelegt wird, daß ein sich selbst verzögernder Ätzprozeß stattfindet. Dies tritt insbesondere dann auf, wenn die Kristallebene des Halbleitersubstrats 1 entsprechend ausgerichtet ist. Das Halbleiterbauelement 12 besteht in diesem Ausführungsbeispiel lediglich aus den durch die beiden Streifen der Bauelementmaske 2 und der Halbleiterschicht 4 gebildeten Schottky-Kontakten und stellt somit eine MSM-Struktur (Metal-Semiconductor-Metal) dar. Des weiteren ist in diesem Fall das Trägersubstrat 9 in Form eines Formstempels aus einem stabilen Material wie z.B. Nickel gebildet. Es weist eine quaderförmige Erhebung 15 auf, die zwischen die Streifen der Bauelementmaske 2 ragt.

Beim weiteren Herstellungsverfahren folgt bei einem als Formstempel dienenden Trägersubstrat 9 als nächster Schritt ein Umgießen des Halbleitersubstrats 1 mit einem flüssigen, aushärtbaren Kunststoff, vorzugsweise einem Polymerkunststoff, dergestalt, daß ein die Größe des Halbleitersubstrats 1 um ein wesentliches überragendes Bauteil erhalten wird. Ist die quaderförmige Erhebung 15 nicht vorhanden, so ist dieses Bauteil als Deckel einsetzbar, wobei dieser dann nach dem Aushärten des flüssigen Kunststoffs vom Trägersubstrat 9 abgehoben und auf ein weiteres Substrat aufgesetzt werden kann. Dieses weitere Substrat besteht dann zweckmäßigerweise ebenfalls aus einem Polymerkunststoff und weist den optischen Wellenleiter 11 auf, der unter dem Halbleiterbauelement 12 zu liegen kommt. Die Justierung des Deckels auf dem weiteren Substrat kann aufgrund der größeren Abmessungen in einfacher Weise mittels eines weiteren Justierelements erfolgen, das insbesondere in die beim Abheben des Deckels vom Formstempel im Deckel verbleibende dachfirstförmige Nut greift, welche durch das Justierelement 10 im Deckel entstanden ist. Ebenso ist aber das entstehende Bauteil als bereits einen Wellenleiter umfassenden Deckel für einen weiteren Montageprozeß verwendbar. Dazu ist bei der Herstellung des Bauteils ein Formstempel zu verwenden, der die quaderförmige Erhebung 15 aufweist, welche im entstehenden Bauteil eine entsprechende Nut hinterläßt, die dann dort als Wellenleiternut dient und sich beim darauffolgenden Klebevorgang mit dem Klebstoff 14 füllt. Für das Halbleitersubstrat 1 ist beispielhaft Indiumphosphid wählbar und für die Halbleiterschicht 4 Indiumgalliumarsenid oder Indiumgalliumarsenidphosphid. Die Bauelementmaske 2 kann ebenso als Ätzmaske oder Diffusionsmaske für das herzustellende Halbleiterbauelement 12 dienen. Anstelle des Photolithographieverfahrens kann ebenso ein anderes Strukturierungsverfahren, wie z.B. das Lift-off-Verfahren eingesetzt werden. Das Verfahren ist ebenso dafür vorgesehen, mit mehreren Justiernuten 8 ausgeführt zu werden, dergestalt, daß eine Justierung in verschiedene Richtungen erfolgt. Die Justiernuten 8 sind dazu vorzugsweise im rechten Winkel zueinander angeordnet.

## Patentansprüche

1. Verfahren zum Herstellen eines Halbleiterbauelements und zum Justieren des Halbleiterbauelements auf einem Trägersubstrat, dadurch gekennzeichnet daß
a) in einem ersten Verfahrensschritt eine Justiermaske (3) für eine Justiernut (8) gemeinsam mit einer Bauelementmaske (2) für das Halbleiterbauelement (12) auf ein Halbleitersubstrat (1) aufgebracht wird und daß
b) in einem zweiten Verfahrensschritt die Justiernut (8) im Halbleitersubstrat (1) durch ein Ätzverfahren unter Zuhilfenahme der Justiermaske (3) hergestellt wird und daß das Halbleiterbauelement (12) im Halbleitersubstrat (1) unter Zuhilfenahme der Bauelementmaske (2) hergestellt und in seiner Position festgelegt wird und daß
c) in einem dritten Verfahrensschritt das Halbleitersubstrat (1) mit dem Halbleiterbauelement (12) und der Justiernut (8) auf das Trägersubstrat (9) aufgesetzt wird, wobei die Lage des Halbleitersubstrats (1) relativ zum Trägersubstrat (9) mittels der Justiernut (8) und einem auf dem Trägersubstrat (9) angeordneten, in die Justiernut (8) ragenden Justierelement (10) justiert wird.

2. Verfahren zum Herstellen eines Halbleiterbauelements und zum Justieren des Halbleiterbauelements auf einem Trägersubstrat, dadurch gekennzeichnet daß
a) in einem ersten Verfahrensschritt eine Justiermaske (3) für eine Justiernut (8) gemeinsam mit einer Bauelementmaske (2) für das Halbleiterbauelement (12) auf ein Halbleitersubstrat (1) aufgebracht wird und daß
b) in einem zweiten Verfahrensschritt die Justiernut (8) im Halbleitersubstrat (1) durch ein Ätzverfahren unter Zuhilfenahme der Justiermaske (3) hergestellt wird und daß das Halbleiterbauelement (12) im Halbleitersubstrat (1) unter Zuhilfenahme der Bauelementmaske (2) hergestellt und in seiner Position festgelegt wird und daß
c) in einem dritten Verfahrensschritt das Halbleitersubstrat (1) mit dem Halbleiterbauelement (12) und der Justiernut (8) auf das Trägersubstrat (9) aufgesetzt wird, wobei die Lage des Halbleitersubstrats (1) relativ zum Trägersubstrat (9) mittels der justiernutseitigen Kante der Justiermaske (3) oder der beim Ätzverfahren mittels der Justiermaske (3) festgelegten Innenkante der Justiernut (8) und einem auf dem Trägersubstrat (9) angeordneten, in die Justiernut (8) ragenden Justierelement (10) justiert wird.

3. Verfahren nach Anspruch 1 oder 2, dadurch gekennzeichnet, daß als Trägersubstrat (9) ein Polymerkunststoff verwendet wird.

4. Verfahren nach Anspruch 3, dadurch gekennzeichnet, daß das Halbleitersubstrat (1) nach dem dritten Verfahrensschritt mittels eines Klebstoffs (14) am Trägersubstrat (9) befestigt wird.

5. Verfahren nach Anspruch 4, dadurch gekennzeichnet, daß als Halbleiterbauelement (12) ein optisches Bauelement, vorzugsweise ein Laser oder ein optischer Detektor, verwendet wird und daß in das Trägersubstrat (9) vor dem Aufsetzen des Halbleitersubstrats (1) eine Wellenleiternut (11) zur Aufnahme eines optischen Wellenleiters eingebettet wird , über der das Halbleiterbauelement (12) beim Aufsetzen zu liegen kommt.

6. Verfahren nach Anspruch 1 oder 2, dadurch gekennzeichnet, daß als Trägersubstrat (9) ein Formstempel verwendet wird und daß das Halbleitersubstrat (1) nach dem dritten Verfahrensschritt mit einem flüssigen, aushärtbaren Kunststoff umgossen wird, und daß das dabei entstehende Bauteil nach dem Aushärten des Kunststoffs vom Trägersubstrat (9) entfernt wird.

7. Verfahren nach Anspruch 6, dadurch gekennzeichnet, daß vor dem Aufsetzen des Halbleitersubstrats (1) auf dem Trägersubstrat (9) eine quaderförmige Erhebung (15) aufgebracht wird, die im Bauteil beim Entfernen eine Nut hinterläßt und daß das Bauteil mit einem Klebstoff (14) auf ein weiteres Substrat geklebt wird, wobei der Klebstoff (14) optisch transparent ist und einen höheren Brechungsindex aufweist, als das weitere Substrat und beim Aufkleben die Nut ausfüllt.

8. Verfahren nach einem der Ansprüche 1 bis 7, dadurch gekennzeichnet, daß das Halbleitersubstrat (1) vor dem dritten Verfahrensschritt entlang der Justiernut (8) gebrochen wird.

9. Verfahren nach einem der Ansprüche 1 bis 7, dadurch gekennzeichnet, daß die Justiernut (8) so hergestellt wird, daß sie in ihrem Inneren spitz zuläuft und daß als Justierelement (10) eine dachfirstförmige Erhebung verwendet wird und daß die Justiernutspitze zur Justierung auf die dachfirstförmige Erhebung aufgelegt wird.

10. Verfahren nach einem der Ansprüche 1 bis 9, dadurch gekennzeichnet, daß ein elektrisch leitfähiges Maskenmaterial, ein dielektrisches Material oder ein Halbleitermaterial für die Justiermaske (3) und die Bauelementmaske (2) verwendet wird.

11. Verfahren nach einem der Ansprüche 1 bis 10, dadurch gekennzeichnet, daß vor dem Ätzen der Justiernut (8) im zweiten Verfahrensschritt der nicht zu ätzende Teil des Halbleitersubstrats (1) mit einer Photolackschicht (7) und einer darunterliegenden Zusatzschicht (6) bedeckt wird.

12. Verfahren nach einem der Ansprüche 1 bis 11, dadurch gekennzeichnet, daß das Halbleiterbauelement (12) hergestellt wird, indem das Halbleitersubstrat (1) im Bereich der Bauelementmaske (2) einem Diffusions- oder Implantationsvorgang ausgesetzt wird.

13. Verfahren nach einem der Ansprüche 1 bis 12, dadurch gekennzeichnet, daß das Halbleiterbauelement (12) hergestellt wird, indem vor dem ersten Verfahrensschritt wenigstens eine Halbleiterschicht (4, 5) auf das Halbleitersubstrat (1) aufgebracht wird.
